# EUROPEAN PATENT APPLICATION

(11) **EP 2 750 489 A1**
(43) Date of publication of application: **02.07.2014**
(21) Application number: 12874644.3
(22) Date of filing: 09.11.2012
(51) Int. Cl.: H05K 3/00

(54) **METHOD FOR DISMANTLING ELECTRONIC COMPONENTS ON A CIRCUIT BOARD BY FINE SAND**

(30) Priority: 16.04.2012 CN 201210111599
(71) Applicant: Institute of Chemistry, Chinese Academy of Science, Beijing 100190 (CN)
(72) Inventor: MA, Yongmei, Beijing 100190 (CN); HUANG, Hai, Beijing 100190 (CN); CAO, Xinyu, Beijing 100190 (CN); ZHANG, Wen, Beijing 100190 (CN); HE, Dan, Beijing 100190 (CN)
(74) Representative: HOFFMANN EITLE
(86) International application number: PCT/CN2012/084382
(87) International publication number: WO 2013/155836

(57) **Abstract**

The present invention relates to the field of recycling circuit boards, and more specifically, to a find-sand disassembly method for removing electronic elements from a circuit board. The method comprises spreading the fine sand on the surface of a heating device for heating the fine sand; heating the fine sand to a temperature equal to or higher than the melting point of the soldering tin on the connector pins of the electronic elements on the circuit board, by means of the heating device; and contacting the side, having fewer electronic elements or no electronic element, of the circuit board with the fine sand, so as to melt the soldering tin and remove the electronic elements from the circuit board. The find-sand disassembly method according to the present invention has many advantages, such as a larger contact area, uniform heating, fast melting of the soldering tin, and lower energy consumption. This method also involves a simply procedure, low cost, and no secondary pollution.

## Description

### Technical Field

The present invention relates to the field of recycling circuit boards, and in particularly, to a method for removing electronic elements from circuit boards.

### Background Art

In recent years, the amount of electronic devices used worldwide has dramatically increased the amount of waste from the electronic and electrical products, such as televisions, computers, mobile phones, and entertaining devices. As estimated, the major electronic waste (e-waste) is in an amount of 1.5 million tons annually in China for now, which accounts for about 1% of the annual total household waste in China and increased at a rate of 13%∼15% per year. Among the e-wastes, the recycling of circuit boards is most complicated while also has the highest value, because they contain many precious metals, such as copper, iron, lead, tin, chromium, cadmium, mercury, nickel, gold, silver, palladium and the like. One of the key steps for recycling circuit boards from these devices is to remove the electronic elements from the circuit boards.

For removing the electronic elements from the circuit boards, the soldering tin used for connecting the connector pins of the electronic elements needs to be melted. Currently, the disassembly methods are, according to the heating mode, classified into a laser disassembly method, a hot-air disassembly method and a liquid disassembly method. The laser disassembly method, due to its extremely high investment cost, can only be applied for special purposes or to specific products, and is very difficult for industrialization. The hot-air disassembly method comprises the steps of continuously blowing hot air at a high temperature (250°C or higher) towards the side, having fewer elements or no elements, of a circuit board; keeping the other side, having elements or more elements, of the circuit board facing downwards; allowing the elements to drop off at which the soldering tin has been melted by shaking the clamping apparatus continually and collecting the dropped elements. In this method, a longer period (1 min or more) of heat exchange is required between the hot air and the soldering tin and the hot air is blown continuously. Thus this method involves high energy consumption with a low efficiency. Moreover, continuous blowing of hot air at a temperature of 250°C or higher raises the temperature in the working chamber, so that some of the elements are damaged or even exploded. The liquid disassembly method includes the steps of using a nonvolatile liquid having a high boiling point as a medium; heating the liquid to a temperature slight higher than the melting point of soldering tin; immersing the side, having fewer elements or no elements, of a circuit board into the liquid; and removing the elements after melting of the soldering tin. This method has some advantages, such as a larger contact area, uniform heating, quick melting of the soldered dot, a short heating period, and better preservation of the elements. Moreover, the liquid disassembly method involves lower energy consumption with high efficiency, because only the power for maintaining a temperature is required after the liquid is heated to the set temperature. However, the liquid medium used in this method typically is selected from organic substances such as silicone oil, paraffin and the like. These substances will remain on the elements and circuit boards and need to be further washed, so that a secondary pollution is resulted. If a tin liquid in a melted state is used as a medium, the above defect can be avoided. However, as tin is very expensive, i.e. the price for each liter of tin is over 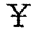 1000, and has a great specific gravity, a higher cost will be caused and great waste is easily resulted.

### Summary of the Invention

The object of the present invention is to provide a simple and low-energy consumption method for melting the soldering tin on the connector pins of the electronic elements on a circuit board.

For achieving this object, the present invention provides a fine-sand disassembly method for removing the electronic elements from a circuit board. The method comprises the steps of spreading fine sand on the surface of a heating device for heating the fine sand; heating the fine sand to a temperature equal to or higher than the melting point of the soldering tin on the connector pins of the electronic elements on the circuit board by the heating device; and contacting the side, having fewer electronic elements or no electronic elements, of the circuit board with the fine sand, so as to melt the soldering tin and remove the electronic elements from the circuit board.

In a preferred embodiment, the fine sand has a particle size of 600 to 10 meshes.

In a preferred embodiment, the method further comprises a step of collecting the melted soldering tin under the fine sand.

In a preferred embodiment, heating is stopped unpon the temperature of the fine sand is higher than the melting point of the soldering tin.

In a preferred embodiment, the fine sand is selected from one or more of natural sand, crushed sand of natural minerals, artificial sand and metal sand.

In a preferred embodiment, the natural sand is selected from one or more of ore sand (such as carborundum), river sand, and sea sand.

In a preferred embodiment, the natural sand is screened before use.

In a preferred embodiment, the crushed sand of natural minerals is fine sand crushed from one or more selected from talc, calcite, marble and granite.

In a preferred embodiment, the artificial sand is selected from one or more of alumina grit (such as white alundum fine sand), silicon carbide grit, silicon nitride grit, ferroferric oxide grit and calcium carbonate grit and the like.

In a preferred embodiment, the metal sand is selected from one or more of iron sand and copper sand and the like.

In a preferred embodiment, the heating device is a heating plate.

In the method according to the present invention, the heat transfer medium is fine sand and the soldering tin on the connector pins of the electronic elements is melt by heating the fine sand, so as to remove the electronic elements from the circuit board. The find-sand disassembly method for removing electronic elements from a circuit board according to the present invention has the following advantages:
(1) The contact area between the fine sand and the soldering tin on the connector pins of the electronic elements is large; the soldering tin is heated evenly and melted quickly; only the power for maintaining a temperature is required after the fine sand is heated to the set temperature; multiple batches or even continuous operation can be carried out; and the energy consumption is much lower than the prior hot-air disassembly method.
(2) During the removing of electronic elements, the operations of the method of the present invention are simple.
(3) The fine sand used in the method of the present invention is nontoxic inorganic substances and metal grit and the like, so this method, unlike liquid disassembly methods, does not result in secondary pollution. Further, the method of the present invention involves a lower cost compared with the disassembly method using a tin liquid as the medium.
(4) The melted soldering tin in the method of the present invention can be recycled easily. Furthermore, while the circuit board is removed from the heat, no soldering tin remains on the board, i.e. without any soldering tin residues.

### Brief Description of the Figures

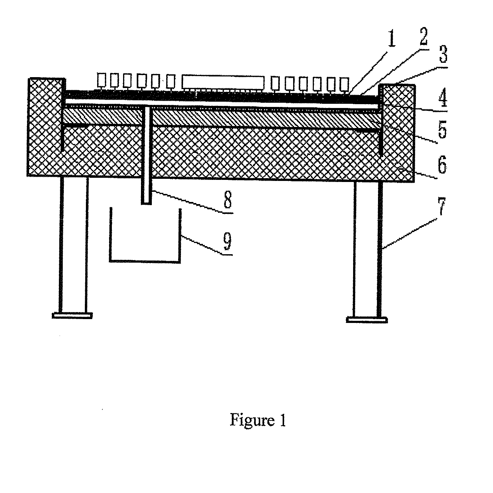

Figure 1 is a schematic diagram showing an experimental device used in Example 1 according to the present invention, in which

| | | | | | |
|---|---|---|---|---|---|
| 1. | circuit board | 2. | fine sand | 3. | square-trough container |
| 4. | netlike plate | 5. | heating plate | 6. | insulation layer |
| 7. | support | 8. | tin liquid recycling tube | 9. | soldering tin collection bucket |

### Detailed Description of the Invention

The present invention provides a method for removing electronic elements from a circuit board by melting the soldering tin on the connector pins of the electronic elements on the circuit board, wherein fine sand is used as a heat transfer medium. This method is also called a find-sand disassembly method. The fine sand that is used as the heat transfer medium has wide sources and can be easily obtained.

The find-sand disassembly method for removing electronic elements from a circuit board according to the present invention comprises the steps of spreading fine sand on the surface of a heating device for heating the fine sand; heating the fine sand to a temperature higher than the melting point of the soldering tin on the connector pins of the electronic elements on the circuit board by the heating device; and contacting the side, having fewer electronic elements or no electronic elements, of the circuit board with the fine sand, so as to melt the soldering tin and remove the electronic elements from the circuit board.

A suitable circuit board for the method of the present invention may be any circuit boards used in electronic and electrical devices, as long as the electronic elements are soldered by soldering tin on the circuit board, which can be easily determined by a person skilled in the art.

Preferably, the fine sand is spread on the surface of a heating device, for example a heating plate, so that the fine sand forms a flat surface. Then the fine sand is heated to a temperature higher than or equal to the melting point of the soldering tin on the connector pins of the electronic elements on the removed circuit board. Subsequently, the side, having fewer electronic elements or no electronic element, of the circuit board is contacted with the fine sand, so as to melt the soldering tin. When the soldering tin on the connector pins of the electronic elements is melted, the electronic elements can be removed from the circuit board.

Preferably, the fine sand used in the method of the present invention has a particle size of 600 to 10 meshes, so as to impart certain fluidity to the fine sand. Such fine sand can be sufficiently contacted with the soldering tin on the connector pins of the electronic elements and provides heat evenly; then the soldering tin is melted quickly, so that the electronic elements can be more easily removed from the circuit board. As a result, the removing process is expedited and the removing efficiency is increased.

Preferably, the method of the present invention further comprises a step of collecting the melted soldering tin below the fine sand. In the method of the present invention, the soldering tin, after melted, forms a tin liquid. Because a tin liquid has a specific gravity much greater than that of the fine sand, and there is interspace between the fine sands, the tin liquid will pass through the interspace between the fine sands quickly due to its gravity and infiltrates to the bottom of the fine sand. Therefore, the tin liquid obtained by melting the soldering tin on the connector pins of the electronic elements or solid soldering tin can be collected at the bottom of or under the fine sand after further cooling and solidification. In addition, the removed electronic elements can be easily recycled over the fine sand.

Preferably, in the method of the present invention, heating is stopped unpon the fine sand reaches a temperature higher than the melting point of the soldering tin. Because fine sand has a better thermal insulation effect, after the fine sand reaches the set temperature, only the power for maintaining a temperature is required to conduct a multiple batches or even a continuous operation. Therefore, in terms of dealing with a great number of circuit boards, the total energy consumption is much lower, and a large-batch or large-scale processing can be achieved.

In the method of the present invention, the fine sand can be selected from, but not limited to, one or more of natural sand, crushed sand of natural minerals, artificial sand and metal sand and the like. Preferably, the natural sand is selected from one or more of ore sand (such as carborundum), river sand, and sea sand, and the like. Preferably, the natural sand is screened before use. Preferably, the crushed sand of natural minerals is selected from one or more of the crushed sand of talc, calcite, and the like. Preferably, the artificial sand is selected from one or more of alumina grit (white alundum fine sand), silicon carbide grit, silicon nitride grit, ferroferric oxide grit and calcium carbonate grit, and the like. Preferably, the metal sand is selected from one or more of iron sand and copper sand, and the like.

Preferably, in the method of the present invention, the heating device is a heating plate.

The devices used to conduct the method of the present invention is not particularly limited, and may be any devices, as long as they can be used to melt the soldering tin on the connector pins of the electronic elements on a circuit board by heating the fine sand. As a preferred example of such device, the device comprises: a heating plate for heating fine sand; a netlike plate set above the heating plate and used for separating fine sand and melted tin liquid; wherein the fine sand is spread on the netlike plate. Preferably, the device comprises a tin liquid recycling tube and a soldering tin collection bucket, wherein the tin liquid recycling tube passes through the heating plate and has a tin liquid inlet located below the netlike plate, so that the melted tin liquid flows into the soldering tin collection bucket through the tin liquid outlet of the tin liquid recycling tube. Preferably, the device comprises an insulation layer set around the heating plate.

The present invention will be further described by referring to the following Examples. However, it should be understood that these Examples are intended for illustrating the present invention only, and not for limiting the scope of the present invention in any way

### Example 1

In Example 1, the experimental device shown in Figure 1 was used to remove the electronic elements from a circuit board. This device comprises square-through container 3, a netlike plate 4, a heating plate 5, an insulation layer 6, supports 7, a tin liquid recycling tube 8 and a soldering tin collection bucket 9, wherein fine sand 2 is used as the heat transfer medium, the electronic elements on a circuit board 1 are required to be removed.

As shown in Figure 1, the square-through container 3, having supports 7 and an interlayer and formed of stainless steel material, was charged with the fine sand 2, as the heat transfer medium. The netlike plate 4, made of stainless steel material and used for separating the fine sand and tin liquid, was installed under the fine sand 2. Below the netlike plate 4, the heating plate 5, made of casting aluminum material, was installed.

The insulation layer 6, made of heat insulating material, was disposed in the interlayer of the square-through container 3.

The tin liquid recycling tube 8 passed through the heating plate 5, so that the inlet (the tin liquid inlet) of the tin liquid recycling tube 8 was located below the netlike plate 4. The soldering tin collection bucket 9 was provided under the outlet (the tin liquid outlet) of the tin liquid recycling tube 8, so as to recycle the melted soldering tin.

Using the above device, the find-sand disassembly method for removing electronic elements from a circuit board according to the present invention was carried out as below:
(1) the carborundum having a particle size of 10 meshes (with a certain fluidity) was spread inside the square-through container 3, wherein the carborundum formed a flat surface;
(2) the carborundum was heated, by turning on the heating plate 5, to a temperature higher than the melting point of the soldering tin on the connector pins of the electronic elements on the removed circuit board, i.e. reaching a preset temperature (it is should be noted that, for example, Sn-Cu series soldering tin, such as Sn-0.75Cu, has a melting point of 227 °C, which is the highest melting point for all types of soldering tin, therefore the temperature of carborundum only needs to be raised to be tens of degrees higher than 227 °C, e.g. about 240 °C, which can be easily determined and achieved by a person skilled in the art); then the temperature rising is stopped and the temperature is maintained constantly;
(3) when the carborundum reached the desired temperature, the side, having fewer electronic elements or no electronic elements, of the circuit board was placed on the flat surface formed by the carborundum, so that the carborundum was sufficiently contacted with the circuit board, and the soldering tin was heated and melted;
(4) when the soldering tin on the connector pins of the electronic elements was melted into a tin liquid, the tin liquid, due to its much greater specific gravity than that of the carborundum, passed through the interspace between the carborundums and infiltrated to the bottom of the carborundum quickly, so that the tin liquid obtained by melting the soldering tin on the connector pins of the electronic elements was collected by the soldering tin recycling tube 8 at the bottom of or under the carborundum, and then the collected tin liquid flowed into the soldering tin collection bucket 9 via the soldering tin recycling tube 8, so as to recycle the soldering tin;
(5) finally, the released or loosened electronic elements were collected over the carborundum, so as to recycle the circuit board.

### Example 2

The electronic elements on a circuit board were removed as in Example 1, except that the white corundum fine sand having a particle size of 600 meshes was spread on a heating device, and preferably the white corundum fine sand formed a flat surface. Then the white corundum fine sand was heated to a temperature higher than the melting point of the soldering tin on the connector pins of the electronic elements on the removed circuit board. After that, the side, having fewer electronic elements or no electronic element, of the circuit board was placed on the surface of the white corundum fine sand, so that the white corundum fine sand was sufficiently contacted with the circuit board, and the soldering tin was heated and melted. When the soldering tin on the connector pins of the electronic elements was melted into a tin liquid, the tin liquid, due to its much greater specific gravity than that of the white corundum fine sand, passed through the interspace between the white corundum fine sands and infiltrated to the bottom of the white corundum fine sand quickly, so that the tin liquid obtained by melting the soldering tin on the connector pins of the electronic elements was collected at the bottom of or under the white corundum fine sand. At the same time, the electronic elements were easily removed from the circuit board, and the released or loosened electronic elements were collected over the white corundum fine sand.

### Example 3

The electronic elements on a circuit board were removed as in Example 1, except that the copper sand having a particle size of 30 meshes (with certain fluidity) was spread on a heating device, and preferably the copper sand formed a flat surface. Then the copper sand was heated to a temperature higher than the melting point of the soldering tin on the connector pins of the electronic elements on the removed circuit board. After that, the temperature rising is stopped and the temperature was maintained constantly. The side, having fewer electronic elements or no electronic element, of the circuit board was placed on the surface of the copper sand, so that the copper sand was sufficiently contacted with the circuit board, and the soldering tin was heated and melted. When the soldering tin on the connector pins of the electronic elements was melted into a tin liquid, the tin liquid, due to its much greater specific gravity than that of the copper sand, passed through the interspace between the copper sands and infiltrated to the bottom of the copper sand quickly, so that the tin liquid obtained by melting the soldering tin on the connector pins of the electronic elements was collected at the bottom of or under the copper sand. At the same time, the electronic elements were easily removed from the circuit board, and the released or loosened electronic elements were collected over the copper sand.

### Example 4

The color sand having a particle size of 40 meshes (obtained by crushing marble, with a main component of calcium carbonate) was spread on the container, and heated to a temperature higher than the melting point of the soldering tin on the connector pins of the electronic elements on the removed circuit board. Then the side, having fewer electronic elements or no electronic element, of the circuit board was placed on the surface of the color sand, so that the color sand was sufficiently contacted with the circuit board, and the soldering tin was heated and melted. When the soldering tin on the connector pins of the electronic elements was melted into a tin liquid, the tin liquid, due to its much greater specific gravity than that of the color sand, passed through the interspace between the color sands and infiltrated to the bottom of the color sand quickly, so that the tin liquid obtained by melting the soldering tin on the connector pins of the electronic elements was collected at the bottom of the color sand. At the same time, the electronic elements were easily removed from the circuit board, and the released or loosened electronic elements were collected over the color sand.

### Example 5

The talc fine sand having a particle size of 400 meshes (obtained by crushing talc) was spread inside a container, and formed a flat surface. Then the talc fine sand was heated to a temperature higher than the melting point of the soldering tin on the connector pins of the electronic elements on the removed circuit board. After that, the temperature rising is stopped and the temperature was maintained constantly. The side, having fewer electronic elements or no electronic element, of the circuit board was placed on the surface of the talc fine sand, so that the talc fine sand was sufficiently contacted with the circuit board, and the soldering tin was heated and melted. When the soldering tin on the connector pins of the electronic elements was melted into a tin liquid, the tin liquid, due to its much greater specific gravity than that of the fine sand, passed through the interspace between the talc fine sands and infiltrated to the bottom of the talc powder quickly, so that the tin liquid obtained by melting the soldering tin on the connector pins of the electronic elements was collected at the bottom of the talc powder. At the same time, the electronic elements were easily removed from the circuit board, and the released or loosened electronic elements were collected over the talc fine sand.

### Example 6

The carborundum having a particle size of 100 meshes and quartz sand having a particle size of 120 meshes were mixed in a mass ratio of 1:1, to generate mixed sand. The mixed sand was then spread on a heating device, so that preferably the mixed sand formed a flat surface. Then the mixed sand was heated to a temperature higher than the melting point of the soldering tin on the connector pins of the electronic elements on the removed circuit board. After that, the temperature rising is stopped and the temperature was maintained constantly. The side, having fewer electronic elements or no electronic element, of the circuit board was placed on the surface of the mixed sand, so that the mixed sand was sufficiently contacted with the circuit board, and the soldering tin was heated and melted. When the soldering tin on the connector pins of the electronic elements was melted into a tin liquid, the tin liquid, due to its much greater specific gravity than that of the mixed sand, passed through the interspace between the mixed sands and infiltrated to the bottom of the mixed sand quickly, so that the tin liquid obtained by melting the soldering tin on the connector pins of the electronic elements was collected at the bottom of or under the mixed sand. At the same time, the electronic elements were easily removed from the circuit board, and the released or loosened electronic elements were collected over the mixed sand.

The above Examples are provided to help the understanding of the present invention only. A person skilled in the art should understand that without deviating from the principle thereof, the present invention can be altered and modified, and all these alterations and modifications fall into the scope sought to be protected by the claims of the present application.

## Claims

1. A find-sand disassembly method for removing electronic elements from a circuit board, comprising:
spreading the fine sand on the surface of a heating device for heating the fine sand; heating the fine sand to a temperature higher than or equal to the melting point of the soldering tin on the connector pins of the electronic elements on the circuit board, by means of the heating device; and contacting the side, having fewer electronic elements or no electronic elements, of the circuit board with the fine sand, so as to melt the soldering tin and remove the electronic elements from the circuit board.

2. The find-sand disassembly method for removing electronic elements from a circuit board according to claim 1, **characterized in that** the fine sand has a particle size of 600 to 10 meshes.

3. The find-sand disassembly method for removing electronic elements from a circuit board according to claim 1, **characterized in that** the method further comprises collecting the melted soldering tin under the fine sand.

4. The find-sand disassembly method for removing electronic elements from a circuit board according to claim 1, **characterized in that** heating is stopped unpon the temperature of the fine sand is higher than the melting point of the soldering tin.

5. The find-sand disassembly method for removing electronic elements from a circuit board according to any one of claims 1-4, **characterized in that** the fine sand is selected from one or more of natural sand, crushed sand of natural minerals, artificial sand and metal sand.

6. The find-sand disassembly method for removing electronic elements from a circuit board according to claim 5, **characterized in that** the natural sand is selected from one or more of ore sand, river sand, and sea sand.

7. The find-sand disassembly method for removing electronic elements from a circuit board according to claim 5, **characterized in that** the natural sand is screened before use.

8. The find-sand disassembly method for removing electronic elements from a circuit board according to claim 5, **characterized in that** the crushed sand of natural minerals is fine sand crushed from one or more selected from talc, calcite, marble and granite.

9. The find-sand disassembly method for removing electronic elements from a circuit board according to claim 5, **characterized in that** the artificial sand is selected from one or more of alumina grit, silicon carbide grit, silicon nitride grit, ferroferric oxide grit and calcium carbonate grit.

10. The find-sand disassembly method for removing electronic elements from a circuit board according to claim 5, **characterized in that** the metal sand is selected from one or more of iron sand and copper sand.

11. The find-sand disassembly method for removing electronic elements from a circuit board according to any one of claims 1-4, **characterized in that** the heating device is a heating plate.
